# EUROPEAN PATENT SPECIFICATION

(11) **EP 4 532 804 B1**
(45) Date of publication and mention of the grant of the patent: **26.08.2026**
(21) Application number: 23734805.7
(22) Date of filing: 30.05.2023
(51) Int. Cl.: C30B 15/10, C09D 1/00, C30B 29/06

(54) **METHODS FOR FORMING SINGLE CRYSTAL SILICON INGOTS WITH REDUCED CARBON CONTAMINATION AND SUSCEPTORS FOR USE IN SUCH METHODS**
VERFAHREN ZUR HERSTELLUNG VON EINKRISTALL-SILICIUMBLÖCKEN MIT REDUZIERTER KOHLENSTOFFKONTAMINATION UND SUSZEPTOREN ZUR VERWENDUNG IN SOLCHEN VERFAHREN
PROCÉDÉS DE FORMATION DE LINGOTS DE SILICIUM MONOCRISTALLIN À CONTAMINATION DE CARBONE RÉDUITE ET SUSCEPTEURS DESTINÉS À ÊTRE UTILISÉS DANS DE TELS PROCÉDÉS

(30) Priority: 01.06.2022 US 202263347897 P
(43) Date of publication of application: 09.04.2025
(73) Proprietor: Globalwafers Co., Ltd., Hsinchu City, 30075 (TW)
(72) Inventor: PHILLIPS, Richard J., St. Peters, Missouri 63376 (US); LUTER, William, St. Peters, Missouri 63376 (US); HUDSON, Carissima Marie, St. Peters, Missouri 63376 (US); RYU, JaeWoo, St. Peters, Missouri 63376 (US)
(74) Representative: Maiwald GmbH
(86) International application number: PCT/US2023/023812
(87) International publication number: WO 2023/235285

(56) References cited:
- WO-A1-02/072926
- WO-A1-2004/053207
- GB-A- 1 448 732
- US-A- 5 858 486
- US-A1- 2014 182 511

## Description

### FIELD OF THE INVENTION

The field of the invention relates to methods for forming single crystal silicon ingots with reduced carbon contamination in a Czochralski process. In embodiments disclosed herein, a protective coating is used to reduce or prevent a reaction between a graphite susceptor and a quartz crucible used during the process. The coating includes boron nitride and a sintering additive that promotes densification of the boron nitride to facilitate preventing or minimizing cross-contamination of the silicon ingot with boron and/or nitrogen.

### BACKGROUND

Single crystal silicon, which is the starting material for most processes for the fabrication of many electronic components such as semiconductor devices and solar cells, is commonly prepared by batch Czochralski (CZ) or Continuous Czochralski (CCZ) methods. In these methods, a polycrystalline source material, such as polycrystalline silicon ("polysilicon"), in the form of solid feedstock material is charged to a quartz crucible and melted, a single seed crystal is brought into contact with the molten silicon or melt, and a single crystal silicon ingot is grown by slow extraction.

Polysilicon may also be directly cast into ingots using a directional solidification process. Wafers sliced from polysilicon ingots are commonly utilized in the electronics industry and in photovoltaic cells used for the production of solar energy. Polysilicon is generally the preferred silicon source for photovoltaic cells rather than single crystal silicon due to its lower cost resulting from higher throughput rates, less labor-intensive operations and the reduced cost of supplies as compared to typical single crystal silicon production. In a directional solidification process, raw silicon is melted in a quartz crucible and directionally solidified in a separate or in the same crucible. The solidification of the ingot is controlled such that molten silicon solidifies unidirectionally at the solidifying front of the casting. The polysilicon produced in such a manner is an agglomeration of crystal grains with the orientation of the grains being random relative to each other due to the high density of heterogeneous nucleation sites at the crucible wall. Once the polysilicon ingot is formed, the ingot may be cut into blocks and further cut into wafers.

In these methods, the quartz crucible is dimensionally unstable at the high temperatures needed to melt the solid feedstock material. To prevent warping or deformation of the crucible during the crystal growth process, the crucible is supported by a susceptor, which is suitably formed from carbon-containing materials such as graphite. Graphite is dimensionally stable at the temperatures needed to melt the silicon feedstock material.

During the crystal growth process, carbon from the graphite susceptor and silica from the quartz crucible may react with one another to generate oxidized carbon and silicon products in a gaseous form, such as by the following reactions:

SiO₂ + C → SiO(g) + CO(g);

and

SiO₂ + 3C → SiC + 2CO(g).

These gaseous products and others (e.g., CO₂) are carried away by inert gases flowing around the susceptor and crucible, and may be swept into the silicon melt, thereby contaminating the melt with carbon. As the gaseous reaction products are carried away by inert gas flow, new carbon and silica surfaces are exposed, thereby promoting continuous reaction between the crucible and the susceptor, and resulting in further contamination of the melt. Silicon crystal ingots grown from the melt, and wafers sliced from such ingots, may have a relatively high carbon concentration.

Carbon contamination is known to contribute to current leakage in semiconductor devices and, consequently, poor performance in semiconductor devices. Thus, it is desirable to minimize carbon contamination of the melt and eliminate potential sources of carbon during the CZ and CCZ crystal growth process.

Continuous reaction between the crucible and the reactor also contributes to erosion of the crucible and the susceptor. Typically, a crucible is used for a single growth process, while the susceptor may be used for multiple runs. However, due to the continuous cycle of erosion of the susceptor, the susceptor rapidly deteriorates, which decreases the useful lifetime of the susceptor. Thus, it is desirable to minimize reaction between the crucible and susceptor to provide a longer lasting susceptor both in the CZ and CCZ crystal growth process as well as the directional solidification process.

Known systems and methods that attempt to address and/or reduce carbon contamination of the melt during a crystal growth process are less than satisfactory to meet current and future carbon requirements for advanced semiconductor devices and/or to prevent cross-contamination of the silicon crystal with material that is used to prevent a reaction between the crucible and the susceptor.

A need exists for methods for preparing silicon crystal ingots that facilitate reducing the carbon content in the silicon crystal and facilitate preventing cross-contamination of the silicon crystal with inert coating materials.

US 2014/0182511 A1 describes a protective coating to prevent reaction between a graphite susceptor and a quartz crucible.

This section is intended to introduce the reader to various aspects of art that may be related to various aspects of the invention, which are described and/or claimed below. This discussion is believed to be helpful in providing the reader with background information to facilitate a better understanding of the various aspects of the present invention. Accordingly, it should be understood that these statements are to be read in this light, and not as admissions of prior art.

### SUMMARY

In one aspect, a method for producing a single crystal silicon ingot from a silicon melt includes providing a graphite susceptor having an interior surface defining a cavity and depositing a coating onto the interior surface of the susceptor. The coating includes boron nitride and a sintering additive. The sintering additive comprises silica, silicon carbide, boric acid, alumina, yttria, zirconia, aluminum nitride, lanthana, or a combination thereof. The sintering additive promotes densification of the boron nitride. Depositing the coating includes: applying a coating composition onto the interior surface of the susceptor, the coating composition comprising the boron nitride, the sintering additive, an organic medium, and a binder; removing the organic medium and the binder from the coating composition applied onto the interior surface of the susceptor to thereby form the coating. The method also includes positioning a quartz crucible in the cavity of the susceptor. The crucible has an outer surface that contacts the coating. The method further includes adding polycrystalline silicon to the crucible, heating the polycrystalline silicon to cause a silicon melt to form in the crucible, and pulling a single crystal silicon ingot from the silicon melt.

In another aspect, a graphite susceptor for supporting a quartz crucible during a crystal growth process includes a body having an interior surface and a coating deposited onto the interior surface. The interior surface defines a cavity. The cavity has a size and shape complementary to an outer size and shape of the crucible. The coating includes boron nitride and a sintering additive. The sintering additive comprises silica, silicon carbide, boric acid, alumina, yttria, zirconia, aluminum nitride, lanthana, or a combination thereof. The sintering additive is configured to promote densification of the boron nitride.

In another aspect, a method for forming a coating between an interior surface of a graphite susceptor and an outer surface of a quartz crucible includes providing a particulate mixture of boron nitride and a sintering additive, depositing the particulate mixture of the boron nitride and the sintering additive onto the interior surface of the susceptor, wherein depositing the particulate mixture includes plasma spraying the particulate mixture onto the interior surface of the susceptor, and sintering the deposited particulate mixture to thereby form the coating. The sintering additive comprises silica, silicon carbide, boric acid, alumina, yttria, zirconia, aluminum nitride, lanthana, or a combination thereof. Sintering the deposited particulate mixture includes promoting densification of the boron nitride using the sintering additive.

Various refinements exist of the features noted in relation to the above-mentioned aspects of the present invention. Further features may also be incorporated in the above-mentioned aspects of the present invention as well. These refinements and additional features may exist individually or in any combination. For instance, various features discussed below in relation to any of the illustrated embodiments of the present invention may be incorporated into any of the above-described aspects of the present invention, alone or in any combination.

### BRIEF DESCRIPTION OF THE DRAWINGS

FIG. 1 is a schematic cross-section side view of a pulling apparatus for forming a single crystal silicon ingot;
FIG. 2 is an exploded, sectional view of a crucible and a susceptor for use in the pulling apparatus shown in FIG. 1, the susceptor having a protective coating in accordance with embodiments of the present invention; and
FIGS. 3A and 3B are schematic illustrations of particulate mixtures of an inert material and a sintering additive for use in preparing the protective coating shown in FIG. 2.

Corresponding reference characters indicate corresponding parts throughout the drawings.

### DETAILED DESCRIPTION

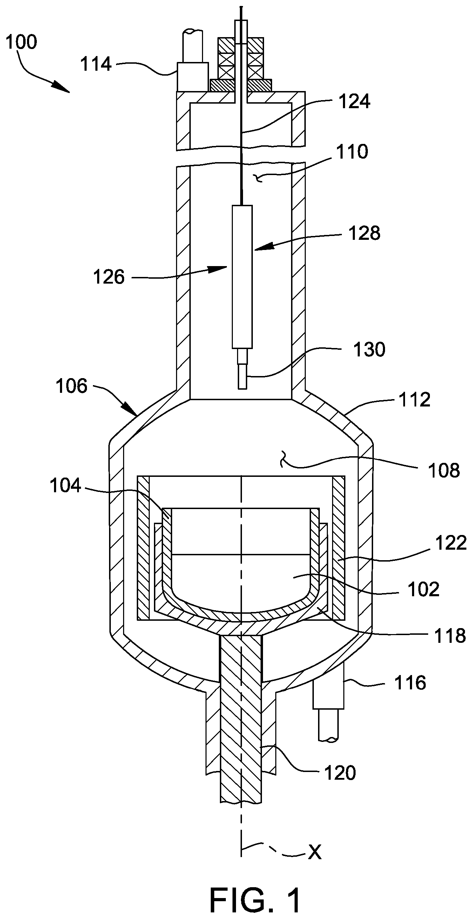

Referring to FIG. 1, an ingot pulling apparatus or ingot puller is shown schematically and is indicated generally at 100. The ingot puller 100 is used to produce single crystal (i.e., monocrystalline) ingots of semiconductor or solar-grade material such as, for example, single crystal silicon ingots. In some embodiments, the ingot is grown by the so-called Czochralski (CZ) process in which the ingot is withdrawn from a silicon melt 102 held within a crucible 104 of crystal puller 100. In some embodiments, the ingot is grown by a batch CZ process in which polycrystalline silicon is charged to the crucible 104 in an amount sufficient to grow one ingot, such that the crucible 104 is essentially depleted of silicon melt 102 after the growth of the one ingot. In other embodiments, the ingot is grown by a continuous CZ (CCZ) process in which polycrystalline silicon is continually or periodically added to crucible 104 to replenish silicon melt 102 during the growth process. The CCZ process facilitates growth of multiple ingots pulled from a single melt 102. Embodiments of the subject matter described herein are not limited to a particular crystal growth process, however. For example, in other embodiments, a polycrystalline silicon ingot may be grown using a directional solidification process for solar applications.

The ingot puller 100 includes a housing 106 that defines a crystal growth chamber 108 and a pull chamber 110 having a smaller transverse dimension than the growth chamber 108. The growth chamber 108 has a generally dome shaped upper wall 112 transitioning from the growth chamber 108 to the narrowed pull chamber 110. The ingot puller 100 includes an inlet port 114 and an outlet port 116 which may be used to introduce and remove a process gas to and from the ingot puller 100 during crystal growth.

The crucible 104 within the ingot puller 100 contains the silicon melt 102 from which a silicon ingot is drawn. The crucible 104 is made of quartz. It should be understood that the crucible 104 may be made from other materials in addition to quartz without departing from the scope of the present invention. For example, the quartz crucible 104 may be made from a composite material that includes silica and an additional material, for example, silicon nitride or silicon carbide.

The silicon melt 102 is obtained by melting polycrystalline silicon charged to the crucible 104. In continuous systems, a feed system (not shown) is used for feeding solid feedstock material into the crucible assembly 104 and/or the melt 102. The crucible 104 is positioned within and supported by a susceptor 118 that is in turn supported by a rotatable shaft 120. Susceptor 118 and rotatable shaft 120 facilitate rotation of the crucible 104 about a central longitudinal axis X of the ingot puller 100.

A heating system 122 (e.g., one or more electrical resistance heaters) surrounds the susceptor 118 and crucible 104 and supplies heat by conduction through the susceptor 118 and crucible 104 for melting the silicon charge to produce the melt 102 and/or maintaining the melt 102 in a molten state. The heater 122 may also extend below the susceptor 118 and crucible 104. The heating system 122 is controlled by a control system (not shown) so that the temperature of the melt 102 is precisely controlled throughout the pulling process. For example, the controller may control electric current provided to the heating system 122 to control the amount of thermal energy supplied by the heating system 122. The controller may control the heating system 122 so that the temperature of the melt 102 is maintained above about the melting temperature of silicon (e.g., about 1412°C). For example, the melt 102 may be heated to a temperature of at least about 1425°C, at least about 1450°C or even at least about 1500°C. Insulation (not shown) surrounding the heating system 122 may reduce the amount of heat lost through the housing 106. The ingot puller 100 may also include a heat shield assembly (not shown) above the surface of melt 102 for shielding the ingot from the heat of the crucible 104 to increase the axial temperature gradient at the solid-melt interface.

A pulling mechanism (not shown) is attached to a pull wire 124 that extends down from the mechanism. The mechanism is capable of raising and lowering the pull wire 124 and rotating the pull wire 124. The ingot puller 100 may have a pull shaft rather than a wire, depending upon the type of puller. The pull wire 124 terminates in a pulling assembly 126 that includes a seed crystal chuck 128 which holds a seed crystal 130 used to grow the silicon ingot. In growing the ingot, the pulling mechanism lowers the seed crystal 130 until it contacts the surface of the silicon melt 102. Once the seed crystal 130 begins to melt, the pulling mechanism slowly raises the seed crystal up through the growth chamber 108 and pull chamber 110 to grow the single crystal ingot. The speed at which the pulling mechanism rotates the seed crystal 130 and the speed at which the pulling mechanism raises the seed crystal (i.e., the pull rate v) are controlled by the control system. As the seed crystal 130 is slowly raised from the melt 102, silicon atoms from the melt 102 align themselves with and attach to the seed crystal 130 to form an ingot.

A process gas (e.g., argon) is introduced through the inlet port 114 into the growth chamber 108 and pull chamber 110 and is withdrawn through the outlet port 116. The process gas creates an atmosphere within the housing and the melt and atmosphere form a melt-gas interface. The outlet port 116 is in fluid communication with an exhaust system (not shown) of the ingot puller.

During operation, the temperatures needed to melt the silicon charge and/or maintain the melt 102 may also cause the quartz crucible 104 to soften. The susceptor 118, which is made of graphite, provides a rigid outer structure for supporting the softened crucible 104. The contact between the crucible 104 and susceptor 118 at the pulling process temperatures may enable silica from the quartz crucible 104 to react with carbon from the susceptor 118. The reactions cause silica to decompose into silicon oxide (SiO) gas and carbon to oxidize forming gaseous carbon-containing reaction products such as, for example, carbon monoxide (CO) and carbon dioxide (CO₂). The graphite susceptor 118 may be eroded as a result, which may create voids or cavities in the susceptor 118. Structural degradation caused by this erosion may decrease the useful lifetime of the susceptor 118 and may require replacement of the susceptor 118. In addition, the process gas flowing through the ingot puller 100 may carry the gaseous carbon-containing reaction products away from the crucible 104 and the susceptor 118 and into the melt 102. This exposes fresh carbon and silica surfaces, leading to continuous formation of gaseous carbon-containing reaction products and erosion of the susceptor 118. The carbon species carried into the melt 102 may travel by convection to the solid-melt interface at which the ingot is grown. As a result, the ingot that is pulled from the melt 102 may be contaminated with carbon. Carbon contamination of the ingot may lead to poorer performance of wafers sliced from the ingot in end-use structures or devices.

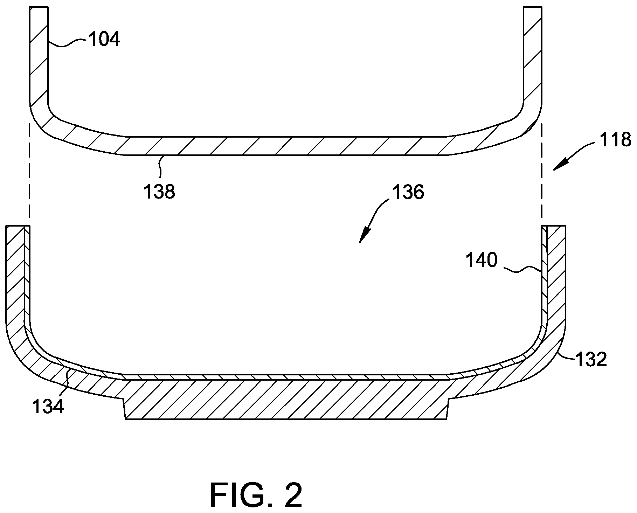

Referring now to FIG. 2, an exploded, sectional view of the susceptor 118 and the crucible 104 is shown. The susceptor 118 includes a body 132 including an interior surface 134 that defines a cavity 136 sized to receive the quartz crucible 104. The crucible 104 has an outer surface 138 that is oriented toward interior surface 134 of the susceptor 118 when the crucible 104 is positioned within the cavity 136. The outer surface 138 of the crucible 104 has a shape that corresponds to the shape of the cavity 136 defined by the interior surface 134 of the susceptor 118, so that the crucible 104 fits into and is supported by the interior surface 134 of the susceptor 118 during a pulling process.

The interior surface 134 of the susceptor 118 is coated with a protective coating 140. The coating 140 may entirely cover or substantially cover the interior surface 134, or may cover at least a portion of the interior surface 134. The crucible 104 contacts the coating 140 during ingot growth. The coating 140 suitably covers a sufficient portion of the interior surface 134 to inhibit or prevent contact between the outer surface 138 of the quartz crucible 104 and the interior surface of the graphite susceptor 118. In some embodiments, the coating 140 may additionally cover areas other than the interior surface 134 to enable the coating 140 to inhibit or prevent contact between the graphite susceptor 118 and the quartz crucible 104 and to otherwise function as described herein. For example, the coating 140 may cover at least a portion of the outer surface 138 of the crucible 104 in addition to covering to the interior surface 134 of the susceptor 118.

The coating 140 is suitably formed from a material that is chemically inert to both the carbon of the susceptor 118 and the silica of the crucible 104 under the pulling process conditions (e.g., at pulling temperatures). In this regard, the coating 140 provides a chemically inert barrier that limits, inhibits, or prevents the direct contact between the graphite susceptor 118 and the quartz crucible 104, and limits, inhibits, or prevents a reaction between the carbon of the susceptor 118 and the silica of the crucible 104 under the processing conditions produced inside the ingot puller 100.

The inert material used to form the coating 140 is boron nitride (BN. Boron nitride is particularly suitable as the inert material due its high thermal and chemical stabilities and resistance to oxidation even at high temperatures. Silicon nitride may tend to form Si-O-N compounds with several stoichiometries at the high temperatures during a pulling process. The Si-O-N bonds as the temperature is increased, for example, above 1550°C, may tend to sublime into other gaseous phases which degrades the coating 140. Boron nitride (BN) does not have a similar tendency to form oxidized products due to the strength of the covalent bonds between the boron and nitrogen atoms, and may have a higher upper temperature bound of functionality than that of silicon nitride.

The coating 140 may be applied as a coating composition that includes particles of the inert material suspended in a liquid solution. Suitably, the coating composition includes the inert material (boron nitride) particles suspended in the liquid solution in an amount that facilitates sufficient overlap between the inert material particles when the coating composition is applied to the interior surface 134 of the susceptor 118. For example, the coating composition may include at least about 5% by weight inert material particles. In some embodiments, the coating composition includes at least about 15% by weight, or even at least about 30% by weight inert material particles. In various embodiments, the coating composition may include from about 5% to about 50% by weight inert material particles, from about 15% to about 50% by weight, from about 10% to about 40% by weight, from about 20% to about 40%, or from about 30% to about 40% by weight inert material particles. In some embodiments, the coating composition includes about 37.5% by weight inert material particles. In some embodiments, the coating composition includes about 25% by weight inert material particles. For purposes of the present invention, and unless specifically described otherwise, percent inclusion of components of the "coating composition" or simply "composition" refer to the material (e.g., the inert material particles suspended in the liquid solution) that is initially applied to the interior surface 134 of the susceptor 118, and not the coating 140 itself which forms after additional processing steps (e.g., vaporization of mediums, heating, or sintering). Unless specifically described otherwise, percent (%) by weight of a component means the amount of the component in the composition, based on the total weight of the composition.

Without being bound by a particular theory, it is believed that the size of the inert material particles can affect the rheology of the coating composition and affect the ease of application. In some embodiments, the average nominal diameter of the inert material particles may be less than about 100 µm. In other embodiments, the average nominal diameter of the inert material particles may be less than about 50 µm, less than about 25 µm or even less than about 10 µm. Utilization of smaller particle sizes generally results in coating compositions with improved fluidity. The boron nitride particles may have a particle size distribution with a d₅₀ (median value) of about 0.5 um, and a d₉₀ of about 0.8 um (i.e., 90% of the particles have a particle size below about 0.8 um). The inert material particles may also be described as powders, or as nanometer sized particles.

When applied in the form of a liquid solution having suspended inert material particles, the coating composition includes additional components such as a medium, binder, dispersant, and a stabilizer. The components are chosen such that the formulation does not devitrify quartz or SiO. Components contemplated for use in the coating composition will now be described.

The composition may include a medium in which the inert material (boron nitride) remains substantially in particulate form. Generally, it should be understood that one or more of the inert material and additives such as a binder, dispersant, and a stabilizer may not dissolve, partially dissolve or fully dissolve in the medium and the terms "medium," "diluent," and "solvent" may be used interchangeably and are not meant to limit embodiments of the present invention to compositions wherein one or more components do or do not dissolve in the medium.

The medium may include an organic compound or may be aqueous. It should be noted, however, that the presence of water in an aqueous solution may result in more oxygen in the cured coating which may react with the graphite susceptor 118 at the higher processing temperatures. Thus, while aqueous solutions may be utilized without departing from the present invention, it may be preferable in some embodiments to use a non-aqueous medium. Preferably the medium vaporizes readily during any drying steps. In examples where an aqueous medium is used for a liquid solution, the composition may be adjusted either in terms of the amount of additional components (e.g., binders, dispersants, and/or stabilizers described further below) that are present so as to achieve a desired fluid viscosity of the liquid coating composition.

The medium may include a C1 to C10 alcohol and may be isopropyl alcohol or ethanol. The amount of the medium is selected to obtain a suitable fluid viscosity of the liquid coating composition. In some embodiments, the coating composition includes at least about 10% by weight medium. In other embodiments, the composition may include at least about 30%, at least about 50%, or even at least about 70% by weight medium. In various other embodiments, the composition includes from about 10% to about 80% by weight medium, from about 30% to about 70%, from about 40% to about 60%, or even from about 45% to about 55% by weight medium. In some embodiments, the composition may include about 49.5% by weight medium. The composition may include more than one medium with the total weight fraction of medium in the composition being as described above. It should be appreciated that the composition may include other amounts of the medium in order to obtain a suitable fluid viscosity of the liquid coating composition. The amount of the medium may vary depending on, for example, the type of medium used **(e.g.,** organic or aqueous). Additionally, a suitable fluid viscosity of the liquid coating composition may vary depending on the technique used to apply the liquid coating composition. For example, as described below, aerosol spraying techniques may require a lower fluid viscosity of the liquid coating composition as compared to brushing techniques.

The coating composition may also include one or more binders which act to bind the components of the composition and, more particularly, the inert material (boron nitride) particles, to the interior surface 134 of the susceptor 118 and to each other after application. Generally, the binder alters the rheology of the coating composition and maintains the distribution of particles in the medium throughout application and drying. In some embodiments, the binder is dissolved in the medium. In some embodiments, the binder is polyvinyl butyral, such as BUTVAR^{®} B-76 (available from Eastman). In some embodiments, the coating composition includes at least about 0.5%, at least about 2%, at least about 5% or at least about 10%, or even at least about 15% by weight binder. In various embodiments, the composition includes from about 0.5% to about 20% by weight binder, from about 0.5% to about 10%, from about 0.5% to about 8%, or from about 2% to about 8% by weight binder. In some embodiments, the coating composition includes about 5.6% by weight binder. In some embodiments, the composition does not include a binder. The composition may include more than one binder with the total weight fraction of binder in the composition being as described above.

The coating composition may also include one or more dispersants. Generally, the dispersant acts to prevent the inert material particles from settling prior to application of the coating composition to the interior surface 134 of the susceptor 118. Suitable dispersants generally do not contribute metallic impurities to the coating composition and are clean burning and decompose during a thermal cycle. The combination of stabilizer (described below) and dispersant may be chosen such that drying of the coating composition to form coating 140 is realized without cracking or with minimal cracking. In some embodiments, the dispersant is a non-aqueous polymeric dispersant such as SOLSPERSE^{®} 20000 (available from Lubrizol Corp.). The coating composition may include at least about 0.05% by weight dispersant and, in other embodiments, at least about 0.1%, at least about 0.5%, at least about 1%, or even at least about 5% by weight dispersant. In various other embodiments, the composition includes from about 0.05% to about 10% by weight dispersant, from about 0.05% to about 5%, or from about 0.5% to about 2.5% by weight dispersant. In some embodiments, the coating composition includes about 1.8% by weight dispersant. In some embodiments, the composition does not include a dispersant. The composition may include more than one dispersant with the total amount of dispersant in the composition being as described above.

The coating composition may also include a stabilizer. Suitable stabilizers generally do not contribute metallic impurities to the coating composition and are clean burning and decompose during a thermal cycle. The combination of stabilizer and dispersant (described above) may be chosen such that drying of the coating composition to form the coating 140 is realized without cracking or with minimal cracking. The stabilizer may be, for example, polyethylene glycol, such as CARBOWAX^{®} Polyethylene Glycol 400 (available from Dow Chemical Co.). The coating composition may include at least about 0.5%, at least about 2%, at least about 5%, at least about 10% or even at least about 15% by weight stabilizer. In various embodiments, the composition includes from about 0.5% to about 20% by weight stabilizer, from about 0.5% to about 10%, from about 0.5% to about 8%, or from about 2% to about 8% by weight stabilizer. In some embodiments, the coating composition includes about 5.6% by weight stabilizer. In some embodiments, the composition does not include a stabilizer. The composition may include more than one stabilizer with the total amount of stabilizer in the composition being as described above.

Examples of techniques for applying the coating composition having inert material particles suspended in a liquid solution include brushing or aerosol spraying. In brushing applications, the coating composition may be painted with a brush (e.g., a foam brush) onto the interior surface 134 of the susceptor 118. In aerosol spraying applications, the coating composition may be applied onto the interior surface 134 of the susceptor 118 using a pressurized spray gun. In general, the coating composition when applied by aerosol spraying has a lower fluid viscosity than when applied by the brushing technique, to enable effective spraying of the coating composition. In this regard, the coating composition may include a lesser amount of inert material particles when applied by aerosol spraying than when applied by brushing. For example, the brushable coating composition may include greater than 30% by weight inert material particles, such as from about 30% to about 50% by weight inert material particles, while the sprayable coating composition may include less than 30% by weight inert material particles, such as from about 5% to about 30% by weight inert material particles. Similarly, the coating composition may have a greater amount of medium when applied by aerosol spraying than when applied by brushing. For example, the brushable coating composition may include greater than 70% by weight medium, such as from about 70% to about 80% by weight medium, while the sprayable coating composition may include less than 60% by weight medium, such as from about 40% to about 60% by weight medium.

The brushing and/or spraying application may be performed under a ventilated hood, suitably at atmospheric pressures and at a temperature below the flash point of the coating composition. The coating composition on the interior surface 134 of the susceptor 118 is subsequently dried, either by air-drying or a thermal treatment, to remove the medium. The dispersant, binder, and/or stabilizer in the coating composition may be included in an amount sufficient to facilitate slowing surface evaporation of the medium so that adequate medium is removed by evaporation from bottom layers. Otherwise, the surface of the outermost layer may skin over too quickly, before adequate medium has been evaporated from the film bulk, which may cause pinholes to form in the coating 140. In some embodiments, the coating composition may be applied and subsequently dried to remove the medium several times to reach a desired thickness.

Once the desired thickness has been achieved, the susceptor 118 may be heated to a temperature sufficient to decompose, vaporize and/or off-gas the remaining liquid components (e.g., the binder, dispersant, stabilizer, any remaining medium, and the like). Generally, heating may be achieved by heating the susceptor 118 having the coating composition applied on the interior surface 134 until the desired temperature is achieved. The binder, dispersant, stabilizer, remaining medium, and the like are removed to form the coating 140. These components may be removed until the coating 140 contains less than 5% by weight residual carbon or less than about 3% or less than about 1% by weight residual carbon. In some embodiments, the susceptor 118 is heated to at least about 150°C, to at least about 200°C, to at least about 300°C, to at least about 400°C, or even to at least about 750°C to remove any binder, stabilizer, dispersant, and remaining medium compounds. In various other embodiments, the susceptor 118 may be heated to from about 100°C to 750°C, or from 400°C to 750°C. The susceptor 118 may be heated for at least about 1 hour and, in other embodiments, at least about 2 hours, at least about 3 hours or from about 1 hour to about 5 hours. In some embodiments, the susceptor 118 is heated to at least about 300° C for at least about 2 hours. The atmosphere may be at a pressure (vacuum) of from about 60 torr (0.08 atm) to about 1 atmosphere or from about 150 torr (0.20 atm) to about 1 atmosphere. In other embodiments, pressures above atmospheric are used such as, for example, pressures of at least 1 atmosphere, at least 2 atmospheres or even at least 5 atmospheres.

The susceptor 118 may be heated in the presence of an inert gas such as, for example, nitrogen, helium or argon. Ambient air may also be used as the atmosphere during heating but is less preferred as it may introduce oxygen into the coating 140. Further, the materials of construction of the furnace as well as the gas flows may be controlled to avoid oxidation of the coating 140 as appreciated by those of skill in the art.

Thereby, the coating 140 includes particulate materials that remain from the coating composition (e.g., inert material particles and sintering additives described in further detail below). A sintering step may also be performed to densify and strengthen the coating 140. This may be performed in addition and subsequent to heating described above to remove the liquid components from the coating composition, or may be performed as a single step to both remove the liquid components to form coating 140 and to sinter coating 140. In certain embodiments, sintering is performed during meltdown of a silicon charge to minimize processing time. To achieve sintering, the susceptor 118 may be heated to a temperature of from about 900°C to about 1600°C. In some embodiments, the susceptor 118 is heated to a temperature of at least about 1000°C, at least about 1100°C, at least about 1400°C, or even at least about 1500°C. The coating 140 may be sintered for a duration of from at least about 1 hour to several days at temperature. In some embodiments, the coating 140 is sintered for at least about 6 hours. The coating 140 may be sintered in the presence of an inert gas such as, for example, nitrogen, helium or argon. The atmosphere may be at a pressure (vacuum) of from about 60 torr (0.08 atm) to about 1 atmosphere or from about 150 torr (0.20 atm) to about 1 atmosphere. In other embodiments, pressures above atmospheric are used such as, for example, pressures of at least 1 atmosphere, at least 2 atmospheres or even at least 5 atmospheres.

The coating 140 may also be formed by other application techniques such as, for example, chemical vapor deposition or plasma spraying. In plasma spraying applications, the inert material particles and additional powdered or particulate additives (e.g., sintering additives described in further detail below) are fed into a hot plasma jet (e.g., a DC plasma torch) through one or more powder feeders where the particles are mixed with plasma gas (e.g., argon, helium, nitrogen, hydrogen, or a combination thereof). The particles have a suitable size distribution (e.g., sizes of about 5 to 100µm) to facilitate adequate mixing and movement through the plasma jet. The particles are accelerated at a high speed (e.g., 50-3000 m/s) and heated rapidly to a high temperature (e.g., of from about 2000°C to about 3000°C) and directed toward the interior surface 134 of the susceptor 118. The softened or molten particles impact the interior surface 134 thereby depositing the coating 140 having a desired thickness between the susceptor 118 and crucible 104. The plasma spraying technique may have several advantages over other deposition techniques, for example, brushing or spraying applications. For example, plasma spraying may facilitate high efficiency in terms of throughput and ease of operation. Plasma spraying may also facilitate reducing processing time, as the need for a separate heating and/or sintering step to form coating 140 may be eliminated. Further, processing conditions of plasma spraying can be controlled to facilitate adjusting coating properties. Moreover, the coating 140 deposited by plasma spraying may suitably be a quasi-permanent interleaved coating 140, reducing the need for reapplication of coating 140 after several pulling processes using susceptor 118, which may be the case when the coating 140 is formed from brushable or sprayable coating compositions.

When the coating 140 is formed, the particles included in the coating 140 (e.g., the inert material particles and additional particles such as a sintering additive described in further detail below) form a film that is interleaved between the graphite susceptor 118 and the quartz crucible 104. The interleaved coating 140 behaves as a sintered monolithic part and exhibits excellent chemical inertness between the graphite susceptor 118 and the quartz crucible 104. It has been observed, however, that an interleaved coating 140 formed essentially of the inert material particles (boron nitride) has minimal strength. Thereby, inert material particles of the coating 140 have the potential to break apart and separate from one another. The loose inert material particles may be carried, for example by the process gas flowing through ingot puller 100, into the silicon melt 102 during a pulling process. The inert material particles may then travel to the solid-melt interface at which the ingot is grown. As a result, the ingot that is pulled from the melt 102 may be contaminated with inert material particles, which negatively impact the resistivity of the ingot and wafers sliced from the ingot. For example, the boron or nitrogen atoms from loose boron nitride particles may be introduced as unintended dopants into melt 102 and may cause fluctuations in ingot resistivity. Moreover, the problem is exacerbated in later pulling processes, as the loose powder continues to break apart from coating 140 over time. The loose powder collects in areas between the susceptor 118 and crucible 104 that cannot be sufficiently cleaned with stopping the pulling process, causing processing delays and increasing manufacturing time and costs. In order to make the coating 140 more functional and take advantage of the reduced reactivity between the carbon and silica surfaces, providing an interleaved coating 140 with greater strength is desired.

To this end, it has been found that sintering additives may be mixed with the inert material particles to facilitate improving the durability of the coating 140 and facilitate minimizing the potential for inert material particles to break apart from the coating 140 and cause detrimental properties in ingots grown using puller 100 via cross-contamination.

Accordingly, in embodiments of the present invention, the coating 140 is formed from a mixture of the inert material particles (boron nitride) and a sintering additive that promotes densification of the inert material particles in the coating 140, and generally improves adherence of the inert material particles to the interior surface 134 of susceptor 118 and to each other. In particular, the sintering additive facilitates diffusion and bonding of the inert material by forming an intergranular liquid phase at sintering temperature (e.g., from about 900°C to about 1600°C), thereby promoting densification of the inert material in the sintered coating 140. The additive includes one or more of silica (silicon dioxide, SiO₂), silicon carbide (SiC), boric acid (hydrogen borate, H₃BO₃), alumina (aluminum dioxide, Al₂O₃), yttria (yttrium oxide, Y₂O₃), zirconia (ZrO₂), aluminum nitride (AlN), and lanthana (lanthanum oxide, (La₂O₃)) .

The sintering additive is included in an amount that is suitable to achieve targeted densification properties of the coating 140. In this regard, the amount of the sintering additive included in the coating 140 may vary considerably to enable a wide range of achievable strength properties of the coating 140. The targeted densification properties may be determined by an acceptable amount of cross-contamination of inert material (boron nitride) in the silicon melt during a pulling process, which in turn may depend on a targeted resistivity of the ingots and wafers sliced from these ingots.

In some examples, the ingots may have a high targeted resistivity. High resistivity ingots may have a targeted resistivity of at least about 5000 ohm-cm, at least about 7500 ohm-cm, at least about 10,000 ohm-cm, or even at least about 100,000 ohm-cm. In these examples, cross-contamination is suitably minimized as unwanted dopants that are introduced into the melt may have a relatively greater effect on resistivity fluctuations. Accordingly, in these examples, the sintering additive may be included in an amount sufficient to form an at least moderately bonded film of inert material (boron nitride) when coating 140 is sintered.

In some examples, the ingots may have a relatively lower targeted resistivity. For example, the ingots may have a targeted resistivity of less than about 5000 ohm-cm, such as less than about 1000 ohm-cm, or even less than about 500 ohm-cm. In these examples, a relatively higher amount of cross-contamination of the inert material (boron nitride) in the silicon melt may be acceptable. Accordingly, in these examples, the sintering additive may be included in an amount sufficient to provide a loose lubricating system for densifying boron nitride when coating 140 is sintered.

Moreover, the amount of the sintering additive included in the coating 140 must be such that the coating 140 retains its inert properties provided by the inert material (boron nitride).

Accordingly, the mass ratio of the sintering additive to inert material (boron nitride) in the coating 140 may be from at least about 1:100 up to about 1:1. Typically, the sintering additive is not added in an amount that would exceed a mass ratio of about 1:1 sintering additive to inert material. In some embodiments, the mass ratio of sintering additive to inert material is about 1:50, about 1:40, about 1:30, about 1:20, about 1:15, about 1:10, about 1:9, about 1:8, about 1:7, about 1:6, about 1:5, about 1:4, about 1:3, about 1:2, or about 1:1. As discussed above, the mass ratio may be selected as any amount suitable to achieve targeted densification properties of the coating 140. In brushing or spraying applications of the coating 140, the liquid coating composition may include at least about 0.01% by weight sintering additive up to about 30% by weight sintering additive. In various embodiments, the liquid coating composition applied by brushing or spraying applications may include from about 1% to about 25% by weight sintering additive, from about 5% to about 20% by weight, or from about 10% to about 15% by weight sintering additive. In plasma spraying applications of the coating 140, the sintering additive may be included in a mass ratio with the inert material particles as described above. Suitably, where the coating 140 is applied by plasma spraying, the mass ratio is from about 1:20 to about 1:1, from about 1:15 to about 1:1, or from about 1:10 to about 1:1 sintering additive to inert material. In one example, where the coating 140 is applied by plasma spraying, the mass ratio is about 1:4 sintering additive to inert material. Where coating 140 is applied by plasma spraying, the sintering additive may be included in an amount of at least about 0.01% up to about 50% by weight, relative to a weight of the inert material particles. In various embodiments, where coating 140 is applied by plasma spraying, the sintering additive is included in an amount of from about 1% to about 50% by weight, from about 10% to about 40% by weight, or from about 20% to about 30% by weight, relative to the weight of the inert material particles. In one example, where coating 140 is applied by plasma spraying, the sintering additive is included in an amount of about 25% by weight, relative to the weight of the inert material particles.

As discussed above, the sintering additives can be applied using thermal coating processes (e.g., plasma spraying) or wet-like coating processes (e.g., brushing or aerosol spraying of liquid coating compositions). The sintering additive is suitably included in an amount sufficient to enable the inert material particles (boron nitride) to stick together to form a dense, hardened coating 140. In this regard, the sintering additive is included to yield the coating 140 that is much less loose than a coating 140 formed entirely, or substantially entirely, from the inert material (boron nitride). Thus, the sintering additive facilitates a lower potential of the coating 140 to particle shed boron nitride and consequently cross-contaminate the melt 102. Moreover, the sintering additive is included in an amount suitable to avoid degrading the thermal durability and inert functionality of the coating 140 as described herein. That is, an excessive amount of the sintering additive may cause the thermal durability of the coating 140 to fall significantly below that of a coating 140 that is formed entirely, or substantially entirely, from the inert material (boron nitride). In one example, the coating 140 is applied by plasma spraying, and the coating 140 is formed from a particulate mixture of boron nitride, as the inert material, and a sintering additive selected from silicon carbide (SiC), yttria (yttrium oxide, Y₂O₃), aluminum nitride (AlN), lanthana (lanthanum oxide, (La₂O₃), and mixtures of two or more of these materials, where the mass ratio of the sintering additive to boron nitride is about 1:4 (i.e., the sintering additive is included in an amount of about 25% by weight, relative to the weight of boron nitride).

Sintering the coating 140 (or the coating composition used to form the coating 140) that includes the inert material particles (boron nitride) and the sintering additive to densify and strengthen the coating 140 may be performed as described above. However, a sintering step is not limited to any particular sintering process, and a sintering step may be utilized whether the coating 140 is formed from a coating composition applied as a liquid solution or is formed by plasma spraying. The sintering additives are suitably capable of functioning as described herein whether they are sintered in vacuum, in an inert gas atmosphere, or in air. In the case of sintering in air, sintering additives that include oxides (e.g., silica, boric acid, alumina, yttria, zirconia, and lanthana) are suitably used as they are the least susceptible to reaction in air during sintering. Moreover, it should be appreciated that several mechanisms could be in effect for sintering. For example, mechanisms such as glassy phase formation between grain boundaries can be initiated as low as 900°C depending on the viscosity of the glassy system, but more typically it will be in the 1200°C to 1800°C range which will depend on a desired process duration at the elevated temperature. Another mechanism involves evaporation and condensation of the sintering additive, where transport and subsequently densification occur by evaporating the sintering additive, with it being vaporously transported, then the constituents condense in a vapor condensation mode with subsequent densification and strength development. Another mechanism is solid diffusion within the sintering additive, again with strength development. The degree of strength or physical property development at a given temperature or pressure will also depend on time duration as a factor as well.

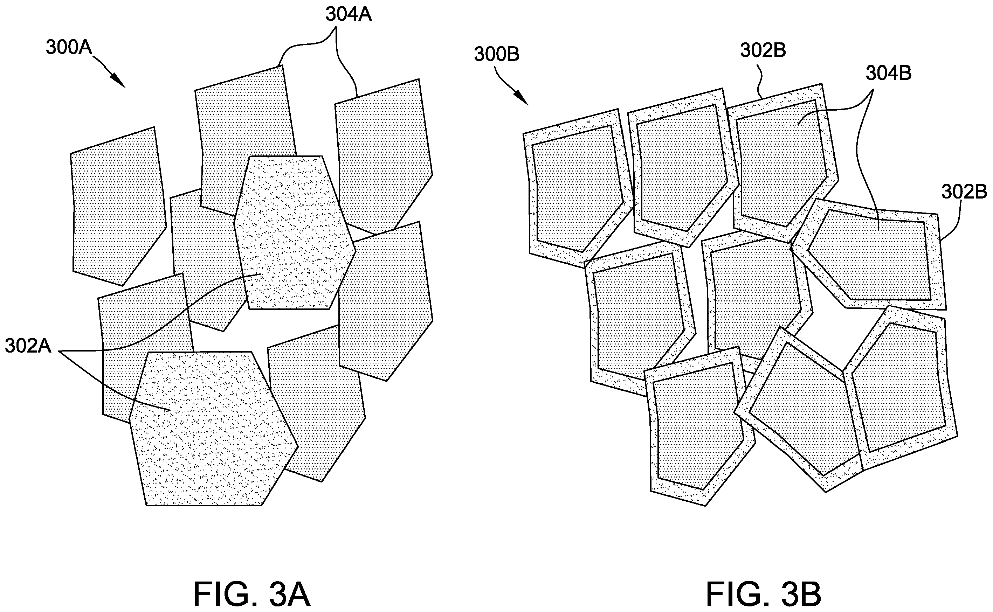

Referring to FIGS. 3A and 3B, example distributions 300A and 300B of mixtures of the sintering additive and the inert material particles (boron nitride) are shown. In particular, these show two example approaches to obtain the mixture of the inert material particles and the sintering additive to facilitate improving the strength of the sintered coating 140.

In FIG. 3A, a separated particulate mixture 300A includes sintering additive particles 302A mixed directly with the inert material particles 304A. The separated particulate mixture 300A may be fed as separate particles 304A of the inert material and particles 302A of the sintering additive to a hot plasma jet for plasma spraying the particles to form the coating 140 (FIG. 2). Additionally, the separated particulate mixture 300A may be added as separate particles 304A of the inert material and particles 302A of the sintering additive to a coating composition, whereby the particles 302A and 304A are suspended in a liquid solution that includes, for example, a medium, dispersant, binder, stabilizer, and the like.

In FIG. 3B, a coated particulate mixture 300B includes the inert material particles 304B coated with the sintering additive 302B. To form the coated particulate mixture 300B, the sintering additive 302B is added to an aqueous solution, and the particles 304B of the inert material are washed with the solution containing the sintering additive 302B. Following the washing to coat the inert material particles 304B, the slurry is dried out to remove the aqueous medium (e.g., water), thereby producing the coated particulate mixture 300B. The coated particulate mixture 300B may subsequently be fed to a hot plasma jet for plasma spraying the coated particulate mixture 300B to form the coating 140 (FIG. 2). Additionally, the coated particulate mixture 300B may be added to a coating composition, whereby the coated particulate mixture 300B is suspended in a liquid solution that includes, for example, a medium, dispersant, binder, stabilizer, and the like.

The two approaches may facilitate a wider range of functionality for mixtures of inert material particles and sintering additive in accordance with the present invention. The selected approach depends on the mass of sintering additive that is intended for use, from which sufficient sintered strength is obtained. As such, the selected approach will depend on the targeted densification properties of the coating 140, the targeted inertness of the coating 140, and/or a tolerance level of cross-contamination. One advantage of the coated particulate mixture 300B (shown in FIG. 3B) is that the mixture 300B provides a higher point contact of the sintering additive 302B against another grain which would be in contact with the sintering additive 302B. Thus, potentially less sintering additive 302B may be necessary in order to obtain mechanical strength of the coating 140. However, the upfront processing of the particulate mixture 300B itself would require some additional process steps in order to obtain such a distribution as well as controlling the particle size of the inert material particles 304B coated with the sintering additive 302B that yields the desired mechanical properties of the coating 140. Conversely, the separated particulate mixture 300A (shown in FIG. 3A) is more of a mechanical mixture which uses the incoming particle size distribution of the sintering additive particles 302A and the inert material particles 304A. The particle to particle contact, where the sintering additive particles 302A are in contact with one another across a grain, has a lower incidence rate, thus a higher weight loading of the sintering additive particles 302A may be necessary. The actual morphology and distribution of the particles may be selected based on factors desired in the final coating 140, such as desired film coating density, scratch resistance, durability etc.

Advantages of using the disclosed coatings include reducing or preventing formation of gaseous products such as oxidized carbon (CO) and silicon (SiO) produced from the reaction between the carbon (C) from the graphite susceptor and the silica (SiO₂) from the quartz crucible (C₍ₛ₎+ SiO₂₍ₛ₎ → CO_{(g)} + SiO_{(g)}). Additional advantages include promoting densification of inert material used to form the coatings, thereby increasing strength of the coatings and reducing cross-contamination of a silicon melt with inert coating material. Moreover, the coatings utilize materials that facilitate a wider range of functionality that can be tailored to targeted specifications of ingots grown by a pulling process. Furthermore, the coatings may suitably be applied as quasi-permanent films, facilitating reducing the frequency of coating applications required between pulling processes.

As used herein, the terms "about," "substantially," "essentially" and "approximately" when used in conjunction with ranges of dimensions, concentrations, temperatures or other physical or chemical properties or characteristics is meant to cover variations that may exist in the upper and/or lower limits of the ranges of the properties or characteristics, including, for example, variations resulting from rounding, measurement methodology or other statistical variation.

When introducing elements of the present invention or the embodiment(s) thereof, the articles "a", "an", "the" and "said" are intended to mean that there are one or more of the elements. The terms "comprising," "including," "containing" and "having" are intended to be inclusive and mean that there may be additional elements other than the listed elements. The use of terms indicating a particular orientation (e.g., "top", "bottom", "side", etc.) is for convenience of description and does not require any particular orientation of the item described.

## Claims

1. A method for producing a single crystal silicon ingot from a silicon melt comprising:
providing a graphite susceptor having an interior surface defining a cavity;
depositing a coating onto the interior surface of the susceptor, the coating comprising boron nitride and a sintering additive, wherein the sintering additive promotes densification of the boron nitride, and wherein the sintering additive comprises silica, silicon carbide, boric acid, alumina, yttria, zirconia, aluminum nitride, lanthana, or a combination thereof, wherein depositing the coating includes:
applying a coating composition onto the interior surface of the susceptor, the coating composition comprising the boron nitride, the sintering additive, an organic medium, and a binder;
removing the organic medium and the binder from the coating composition applied onto the interior surface of the susceptor to thereby form the coating;
positioning a quartz crucible in the cavity of the susceptor, the crucible having an outer surface that contacts the coating;
adding polycrystalline silicon to the crucible;
heating the polycrystalline silicon to cause a silicon melt to form in the crucible; and
pulling a single crystal silicon ingot from the silicon melt.

2. The method as set forth in claim 1 wherein a mass ratio of the sintering additive to the boron nitride in the coating is from 1:20 to 1:1.

3. The method as set forth in claim 1 further comprising sintering the coating during and/or after removing the organic medium and the binder.

4. The method as set forth in any one of claims 1 and 3 wherein the coating composition comprises from 0.1% to 50%, by weight, of the boron nitride.

5. The method as set forth in any one of claims 1, 3 and 4 wherein a mass ratio of the sintering additive to the boron nitride in the coating is from 1:100 to 1:1.

6. A graphite susceptor for supporting a quartz crucible during a crystal growth process, the susceptor comprising:
a body having an interior surface defining a cavity, the cavity having a size and shape complementary to an outer size and shape of the crucible; and
a coating deposited onto the interior surface, the coating comprising boron nitride and a sintering additive, wherein the sintering additive is configured to promote densification of the boron nitride, and wherein the sintering additive comprises silica, silicon carbide, boric acid, alumina, yttria, zirconia, aluminum nitride, lanthana, or a combination thereof.

7. The susceptor as set forth in claim 6
wherein a mass ratio of the sintering additive to the boron nitride in the coating is from 1:100 to 1:1.

8. The susceptor as set forth in claim 6
wherein a mass ratio of the sintering additive to the boron nitride in the coating is from 1:20 to 1:1.

9. The susceptor as set forth in any one of claims 6 to 8 wherein a mass ratio of the sintering additive to the boron nitride in the coating is from 1:5 to 1:1.

10. A method for forming a coating between an interior surface of a graphite susceptor and an outer surface of a quartz crucible, the method comprising:
providing a particulate mixture of boron nitride and a sintering additive, wherein the sintering additive comprises silica, silicon carbide, boric acid, alumina, yttria, zirconia, aluminum nitride, lanthana, or a combination thereof;
depositing the particulate mixture of the boron nitride and the sintering additive onto the interior surface of the susceptor, wherein depositing the particulate mixture includes plasma spraying the particulate mixture onto the interior surface of the susceptor; and
sintering the deposited particulate mixture to thereby form the coating, wherein sintering the deposited particulate mixture includes promoting densification of the boron nitride using the sintering additive.

11. The method as set forth in claim 10 wherein sintering the deposited particulate mixture occurs during and/or after depositing the particulate mixture.

12. The method as set forth in claim 10 or claim 11 wherein providing the particulate mixture includes mixing separate particles of the boron nitride and the sintering additive to form a separated particulate mixture and wherein depositing the particulate mixture includes plasma spraying the separated particulate mixture onto the interior surface of the susceptor.

13. The method as set forth in claim 10 or claim 11 wherein providing the particulate mixture includes providing a coated particulate mixture comprising particles of the boron nitride coated with the sintering additive and wherein depositing the particulate mixture includes plasma spraying the coated particulate mixture onto the interior surface of the susceptor.

## Patentansprüche

1. Ein Verfahren zur Herstellung eines Einkristall-Siliziumingots aus einer Siliziumschmelze, umfassend:
Bereitstellen eines Graphitsuszeptors mit einer Innenfläche, die einen Hohlraum begrenzt;
Aufbringen einer Beschichtung auf die Innenfläche des Suszeptors, wobei die Beschichtung Bornitrid und ein Sinteradditiv umfasst, wobei das Sinteradditiv die Verdichtung des Bornitrids fördert und wobei das Sinteradditiv Siliziumdioxid, Siliziumkarbid, Borsäure, Aluminiumoxid, Yttriumoxid, Zirkonoxid, Aluminiumnitrid, Lanthanoxid oder eine Kombination davon umfasst, wobei das Aufbringen der Beschichtung Folgendes umfasst:
Aufbringen einer Beschichtungszusammensetzung auf die Innenfläche des Suszeptors, wobei die Beschichtungszusammensetzung das Bornitrid, das Sinteradditiv, ein organisches Lösemittel und ein Bindemittel umfasst;
Entfernen des organischen Lösemittels und des Bindemittels aus der auf die Innenfläche des Suszeptors aufgetragenen Beschichtungszusammensetzung, um dadurch die Beschichtung zu bilden;
Anordnen eines Quarz-Tiegels im Hohlraum des Suszeptors, wobei der Tiegel eine Außenfläche aufweist, die mit der Beschichtung in Kontakt steht;
Zugeben von polykristallinem Silizium in den Tiegel;
Erhitzen des polykristallinen Siliziums, um die Bildung einer Siliziumschmelze im Tiegel zu bewirken; und
Ziehen eines Einkristall-Siliziumingots aus der Siliziumschmelze.

2. Das Verfahren nach Anspruch 1, wobei das Massenverhältnis des Sinteradditivs zum Bornitrid in der Beschichtung von 1:20 bis 1:1 beträgt.

3. Das Verfahren nach Anspruch 1, das ferner das Sintern der Beschichtung während und/oder nach dem Entfernen des organischen Lösemittels und des Bindemittels umfasst.

4. Das Verfahren nach einem der Ansprüche 1 und 3, wobei die Beschichtungszusammensetzung 0,1 bis 50 Gew.-% des Bornitrids umfasst.

5. Das Verfahren nach einem der Ansprüche 1, 3 und 4, wobei das Massenverhältnis des Sinteradditivs zum Bornitrid in der Beschichtung von 1:100 bis 1:1 beträgt.

6. Ein Graphit-Suszeptor zum Tragen eines Quarz-Tiegels während eines Kristallwachstumsprozesses, wobei der Suszeptor umfasst:
einen Körper mit einer Innenfläche, die einen Hohlraum begrenzt, wobei der Hohlraum eine Größe und Form aufweist, die zur Außengröße und -form des Tiegels komplementär sind; und
eine auf die Innenfläche aufgebrachte Beschichtung, wobei die Beschichtung Bornitrid und ein Sinteradditiv umfasst, wobei das Sinteradditiv dazu ausgelegt ist, die Verdichtung des Bornitrids zu fördern, und wobei das Sinteradditiv Siliziumdioxid, Siliziumkarbid, Borsäure, Aluminiumoxid, Yttriumoxid, Zirkonoxid, Aluminiumnitrid, Lanthanoxid oder eine Kombination davon umfasst.

7. Der Suszeptor gemäß Anspruch 6, wobei das Massenverhältnis des Sinteradditivs zum Bornitrid in der Beschichtung von 1:100 bis 1:1 beträgt.

8. Der Suszeptor nach Anspruch 6, wobei das Massenverhältnis des Sinteradditivs zum Bornitrid in der Beschichtung von 1:20 bis 1:1 beträgt.

9. Der Suszeptor gemäß einem der Ansprüche 6 bis 8, wobei das Massenverhältnis des Sinteradditivs zum Bornitrid in der Beschichtung von 1:5 bis 1:1 beträgt.

10. Ein Verfahren zum Bilden einer Beschichtung zwischen einer Innenfläche eines Graphit-Suszeptors und einer Außenfläche eines Quarz-Tiegels, wobei das Verfahren umfasst:
Bereitstellen einer Partikelmischung aus Bornitrid und einem Sinteradditiv, wobei das Sinteradditiv Siliciumdioxid, Siliziumkarbid, Borsäure, Aluminiumoxid, Yttriumoxid, Zirkonoxid, Aluminiumnitrid, Lanthanoxid oder eine Kombination davon umfasst;
Aufbringen der Partikelmischung aus Bornitrid und dem Sinteradditiv auf die Innenfläche des Suszeptors, wobei das Aufbringen der Partikelmischung das Plasmaversprühen der Partikelmischung auf die Innenfläche des Suszeptors umfasst; und
Sintern der aufgebrachten Partikelmischung, um dadurch die Beschichtung zu bilden, wobei das Sintern der aufgebrachten Partikelmischung die Förderung der Verdichtung des Bornitrids durch das Sinteradditiv umfasst.

11. Das Verfahren nach Anspruch 10, wobei das Sintern der aufgebrachten Partikelmischung während und/oder nach dem Aufbringen der Partikelmischung erfolgt.

12. Das Verfahren nach Anspruch 10 oder Anspruch 11, wobei das Bereitstellen der Partikelmischung das Vermischen separater Partikel des Bornitrids und des Sinteradditivs umfasst, um eine Mischung separater Partikel zu bilden, und wobei das Aufbringen der Partikelmischung das Plasmaversprühen der Mischung separater Partikel auf die Innenfläche des Suszeptors umfasst.

13. Das Verfahren nach Anspruch 10 oder Anspruch 11, wobei das Bereitstellen der Partikelmischung das Bereitstellen einer beschichteten Partikelmischung umfasst, die Partikel des Bornitrids enthält, die mit dem Sinteradditiv beschichtet sind, und wobei das Aufbringen der Partikelmischung das Plasmaversprühen der beschichteten Partikelmischung auf die Innenfläche des Suszeptors umfasst.

## Revendications

1. Procédé de production d'un lingot de silicium monocristallin à partir d'un bain de silicium fondu comprenant :
la fourniture d'un suscepteur en graphite ayant une surface intérieure définissant une cavité ;
le dépôt d'un revêtement sur la surface intérieure du suscepteur, le revêtement comprenant du nitrure de bore et un additif de frittage, l'additif de frittage favorisant la densification du nitrure de bore, et l'additif de frittage comprenant de la silice, du carbure de silicium, de l'acide borique, de l'alumine, de l'yttria, de la zircone, du nitrure d'aluminium, de la lanthane, ou une combinaison de ceux-ci, le dépôt du revêtement comprenant :
l'application d'une composition de revêtement sur la surface intérieure du suscepteur, la composition de revêtement comprenant le nitrure de bore, l'additif de frittage, un milieu organique, et un liant ;
l'élimination du milieu organique et du liant de la composition de revêtement appliquée sur la surface intérieure du suscepteur pour former ainsi le revêtement ;
le positionnement d'un creuset en quartz dans la cavité du suscepteur, le creuset ayant une surface extérieure qui entre en contact avec le revêtement ;
l'ajout de silicium polycristallin au creuset ;
le chauffage du silicium polycristallin pour provoquer la formation d'un bain de silicium fondu dans le creuset ; et
le tirage d'un lingot de silicium monocristallin à partir du bain de silicium fondu.

2. Procédé selon la revendication 1, dans lequel un rapport massique de l'additif de frittage au nitrure de bore dans le revêtement est de 1:20 à 1:1.

3. Procédé selon la revendication 1, comprenant en outre le frittage du revêtement pendant et/ou après l'élimination du milieu organique et du liant.

4. Procédé selon l'une quelconque des revendications 1 et 3, dans lequel la composition de revêtement comprend de 0,1 % à 50 %, en poids, du nitrure de bore.

5. Procédé selon l'une quelconque des revendications 1, 3 et 4, dans lequel un rapport massique de l'additif de frittage au nitrure de bore dans le revêtement est de 1:100 à 1:1.

6. Suscepteur en graphite pour supporter un creuset en quartz pendant un processus de croissance cristalline, le suscepteur comprenant :
un corps ayant une surface intérieure définissant une cavité, la cavité ayant une taille et une forme complémentaires à une taille et une forme extérieure du creuset ; et
un revêtement déposé sur la surface intérieure, le revêtement comprenant du nitrure de bore et un additif de frittage, l'additif de frittage étant conçu pour favoriser la densification du nitrure de bore, et l'additif de frittage comprenant de la silice, du carbure de silicium, de l'acide borique, de l'alumine, de l'yttria, de la zircone, du nitrure d'aluminium, de la lanthane, ou une combinaison de ceux-ci.

7. Suscepteur selon la revendication 6, dans lequel un rapport massique de l'additif de frittage au nitrure de bore dans le revêtement est de 1:100 à 1:1.

8. Suscepteur selon la revendication 6, dans lequel un rapport massique de l'additif de frittage au nitrure de bore dans le revêtement est de 1:20 à 1:1.

9. Suscepteur selon l'une quelconque des revendications 6 à 8, dans lequel un rapport massique de l'additif de frittage au nitrure de bore dans le revêtement est de 1:5 à 1:1.

10. Procédé de formation d'un revêtement entre une surface intérieure d'un suscepteur en graphite et une surface extérieure d'un creuset en quartz, le procédé comprenant :
la fourniture d'un mélange particulaire de nitrure de bore et d'un additif de frittage, l'additif de frittage comprenant de la silice, du carbure de silicium, de l'acide borique, de l'alumine, de l'yttria, de la zircone, du nitrure d'aluminium, de la lanthane, ou une combinaison de ceux-ci ;
le dépôt du mélange particulaire du nitrure de bore et de l'additif de frittage sur la surface intérieure du suscepteur, le dépôt du mélange particulaire comprenant la projection par plasma du mélange particulaire sur la surface intérieure du suscepteur ; et
le frittage du mélange particulaire déposé pour former ainsi le revêtement, le frittage du mélange particulaire déposé comprenant la promotion de la densification du nitrure de bore au moyen de l'additif de frittage.

11. Procédé selon la revendication 10, dans lequel le frittage du mélange particulaire déposé se produit pendant et/ou après le dépôt du mélange particulaire.

12. Procédé selon la revendication 10 ou 11, dans lequel la fourniture du mélange particulaire comprend le mélange de particules séparées du nitrure de bore et de l'additif de frittage pour former un mélange particulaire séparé et dans lequel le dépôt du mélange particulaire comprend la projection par plasma du mélange particulaire séparé sur la surface intérieure du suscepteur.

13. Procédé selon la revendication 10 ou 11, dans lequel la fourniture du mélange particulaire comprend la fourniture d'un mélange particulaire enrobé comprenant des particules du nitrure de bore enrobées de l'additif de frittage et dans lequel le dépôt du mélange particulaire comprend la projection par plasma du mélange particulaire enrobé sur la surface intérieure du suscepteur.
